# EUROPÄISCHE PATENTSCHRIFT

(11) **EP 2 087 595 B1**
(45) Veröffentlichungstag und Bekanntmachung des Hinweises auf die Patenterteilung: **24.02.2010**
(21) Anmeldenummer: 07846507.7
(22) Anmeldetag: 24.10.2007
(51) Int. Cl.: H03M 1/06, H03M 1/52, G01R 17/10

(54) **MESSVERTÄRKUNGSVORRICHTUNG UND -VERFAHREN**
MEASUREMENT AMPLIFICATION DEVICE AND METHOD
DISPOSITIF ET PROCÉDÉ D'AMPLIFICATION DE MESURE

(30) Priorität: 27.10.2006 DE 102006051365
(43) Veröffentlichungstag der Anmeldung: 12.08.2009
(73) Patentinhaber: SARTORIUS AG, 37075 Göttingen (DE)
(72) Erfinder: FELDOTTE, Heinrich, 37079 Göttingen (DE); KLAUER, Alfred, 37083 Göttingen (DE)
(86) Internationale Anmeldenummer: PCT/EP2007/009231
(87) Internationale Veröffentlichungsnummer: WO 2008/049602

(56) Entgegenhaltungen:
- DE-A1- 3 633 790
- DE-A1- 3 710 904
- JP-A- 60 143 026

## Beschreibung

### Gebiet der Erfindung

Die Erfindung bezieht sich auf eine Messverstärkungsvorrichtung zur Erfassung einer Verstimmung einer mit einer bipolaren, rechteckförmigen Speisespannung gespeisten Messbrücke.

Die Erfindung bezieht sich weiter auf ein Messverstärkungsverfahren zur Erfassung einer Verstimmung einer mit einer bipolaren, rechteckförmigen Speisespannung gespeisten Messbrücke.

### Stand der Technik

Bekannte Vorrichtungen weisen einen integrierenden A/D-Wandler auf, der einen digitalen, für die Brückenverstimmung repräsentativen Ausgangswert auf Basis eines analogen, bipolaren Verstimmungssignals der Messbrücke erzeugt. Dabei weist der A/D-Wandler einen Integrator auf; der ein bei Betrieb dauerhaft an ihn angelegtes Messsignal und einen zeitweise an ihn angelegten Arbeitspegel eines Referenzsignals integriert. Weiter weist der A/D-Wandler einen dem Integrator nachgeschalteten Komparator auf, der ein Integrator-Ausgangssignal mit einem Schwellenwert vergleicht. Der Komparator ermittelt jeden Zeitpunkt, zu dem das Integrator-Ausgangssignal den Schwellenwert quert. Mittels eines zu einer schaltbaren Referenzspannungsquelle rückgekoppelten Komparator-Ausgangssignals steuert der Komparator das zeitweise Anlegen des Arbeitspegels des Referenzsignals. Dabei erfassen Zeitmessmittel die Dauer jedes Messintervalls, da dadurch definiert ist, dass während seiner Dauer der Arbeitspegel des Referenzsignals an den Integrator angelegt ist, als Basis eines Maßes für die Brückenverstimmung erfassen.

Derartige Verfahren und Vorrichtungen zur digitalisierenden Erfassung von Messsignalen, insbesondere von Verstimmungssignalen einer Messbrücke, sind unter dem Begriff der Trägerfrequenz-Verstärkung bzw. -Wandlung bekannt. Der Begriff der "Messbrücke" ist dabei weit zu verstehen und umfasst nicht nur die klassische Wheatstone-Brücke, sondern auch sog. Halbbrücken und andere mit einer Speisespannung gespeiste Schaltungen mit wenigstens einem veränderlichen Widerstand, dessen Veränderung zu einer Verstimmung einer an der Schaltung abgreifbaren Verstimmungsspannung führt.

Vor Einführung des Trägerfrequenz-Prinzips wurde ein Gleichspannungs-Messsignal, z.B. das Verstimmungssignal einer Messbrücke, mittels eines Gleichspannungsverstärkers vorverstärkt und anschließend in einem integrierenden A/D-Wandler digitalisiert.

Das Prinzip des integrierenden A/D-Wandlers ist in vielfältigen Varianten seit Langem bekannt. Beispielhaft seien hier die DE 21 14 141, die DE 28 20 601 C2 sowie die DE 100 40 373 A1 genannt. Beim integrierenden A/D-Wandler wird das Messsignal an einen Eingang eines als Integrator beschalteten Operationsverstärkers angelegt. Zur Beschaltung als Integrator wird der Ausgang des Operationsverstärkers über einen Kondensator mit seinem Messsignal-Eingang verbunden. Ebenfalls mit dem Messsignal-Eingang des Operationsverstärkers verbunden ist die Zuleitung für ein Gleichspannungs-Referenzsignal. Dieses Referenzsignal wird nur zeitweise mit einem Arbeitspegel zugeschaltet. Während der übrigen Zeit liegt es mit einem betragsmäßig niedrigeren Ruhepegel an oder ist vollständig von dem Eingang des Operationsverstärkers getrennt. Während eines ersten Taktanteils eines Messtaktes, in dem der Arbeitspegel des Referenzsignals nicht anliegt, wird der Kondensator durch das im Operationsverstärker verstärkte Messsignal aufgeladen. Wird nach einer vorgegebenen Zeitspanne der Arbeitspegel des Referenzsignals zugeschaltet, entlädt sich der Kondensator während eines zweiten Taktanteils, wodurch das Integrator-Ausgangssignal abfällt. Der Zeitpunkt eines Null-Durchgangs oder allgemeiner eines Schwellenwert-Durchgangs des Integrator-Ausgangssignal wird mittels eines nachgeschalteten Komparators erfasst, der seinerseits über Steuermittel veranlasst, dass der Arbeitspegel des Referenzsignals wieder vom Integrator-Eingang getrennt wird, so dass ein neuer Messtakt mit der Aufladung des Kondensators beginnen kann. Die Dauer des zweiten Taktanteils, d.h. die Zeitspanne, während derer der Arbeitspegel des Referenzsignals am Integrator anliegt, wird mit geeigneten Zeitmessmitteln, beispielsweise einem getakteten Zähler, gemessen. Die gemessene Zeitdauer, hier als Messintervall bezeichnet, stellt ein Maß für die im ersten Taktanteil erfolgte Aufladung des Kondensators und somit für den Pegel des Messsignals dar. Im Fall der Zeitmessung mittels getakteten Zählers kann der Zählerwert unmittelbar als digitales Maß für das Messsignal, d.h. insbesondere das Verstimmungssignal der Messbrücke, benutzt werden.

In der Vergangenheit bereitete eine präzise Vorverstärkung des Gleichspannungs-Messsignals Schwierigkeiten wegen damit verbundener Offset-Spannungen und deren Drift. Teilweise Abhilfe wurde durch Einführung des Trägerfrequenz-Prinzips erreicht, das auch Vorteile im Hinblick auf die Unterdrückung des 1/f-Rauschens zeigt. Dabei wird die Messbrücke mit einem bipolaren Rechtecksignal gespeist. Hieraus ergibt sich ein ebenfalls bipolares, rechteckiges Verstimmungssignal der Messbrücke. Dieses lässt sich mit bekannten Wechselspannungs-Verstärkern vorverstärken. Das vorverstärkte Wechselspannungssignal kann anschließend durch phasenrichtige Gleichrichtung und nachfolgende Tiefpassfilterung in ein Gleichspannungs-Messsignal verwandelt werden. Dies ist aus der DE 2164315 bekannt. Die anschließende Digitalisierung des Gleichspannungs-Messsignals kann wie oben erläutert erfolgen.

Alternativ zur phasenrichtigen Gleichrichtung und anschließenden Tiefpassfilterung ist aus der WO 03/087749 A2 ein System bekannt, in dem das vorverstärkte Wechselspannungs-Verstimmungssignal unmittelbar und hochfrequent abgetastet wird, wobei als Maß für die Brückenverstimmung die Differenz der Mittelwerte der in jeweils benachbarten Halbperioden des bipolaren Verstimmungssignals erfassten Abtastwerte verwendet wird. Dieses Verfahren hat gegenüber dem zuvor erläuterten Verfahren der phasenrichtigen Gleichrichtung und anschließenden Tiefpassfilterung den Vorteil einer digitalen Eliminierung von Offset und Drift des Wechselspannungs-Vorverstärkers. Nachteilig dabei ist jedoch die Notwendigkeit eines sehr hochfrequenten aber in seiner Auflösung begrenzten Abtasters.

Aus der DE 36 33 790 A1 ist eine Vorrichtung mit Spannungs/Frequenz-Wandlung eines Verstimmungssignals einer Messbrücke bekannt, wobei nach dem Prinzip abwechselnder Auf- und Abintegration des Verstimmungssignals und des Vergleichens mit einem Schwellenwert in einem Komparator ein Pulszug erzeugt wird, dessen Frequenz repräsentativ für die Brückenverstimmung ist. Bei der bekannten Vorrichtung wird die Speisespannung der Messbrücke willkürlich gemäß einem externen Polaritätswechseltakt umgepolt. Entsprechend wechselt auch das an der Messbrücke anliegende Verstimmungssignal seine Polarität, was in der Regel während einer Aufintegrationsphase geschieht, gegen deren Dauer die Dauer der Abintegrationsphase vernachlässigbar kurz ist. Um hierdurch keinen fehlverschobenen Puls in dem Pulszug zu erhalten, wird ein Ladungsbalance-Zyklus in Gang gesetzt, der eine Verzögerung des auszugebenden Pulses, der auch die nächste Abintegrationsphase einleitet, bewirkt. Diese Vorrichtung weist mehrere Nachteile auf. Erstens ist bereits die Erzeugung eines Pulszuges, dessen Frequenz für die Berechung eines Messspannungswertes gemessen werden muss, ungünstig, weil dies einerseits technisch aufwendig und andererseits langwierig ist, da zur genauen Messung einer Frequenz viele Pulse, d.h. viele Auf- und Abintegrationsphasen in Betracht gezogen werden müssen. Zweitens beruht das Prinzip auf der Vernachlässigung von Offset-Spannungen, Kondensator-Restspannungen und der für die Abintegration benötigten Zeiten. Dies mögen in vielen Fällen realistische Annahmen sein. Bei sehr schnellen und/oder sehr genauen Messerfordernissen, können solche Faktoren jedoch nicht mehr vernachlässigt werden, sodass das bekannte Messverfahren bzw. die entsprechende Vorrichtung hier nicht einsetzbar sind. Drittens erfordert der Ladungsbalance-Zyklus eine Vielzahl zusätzlicher Bauteile, was einen entsprechend höheren technischen Aufwand und Energieverbrauch bedeutet.

Aus der DE 42 22 580 A1 ist eine herkömmliche A/D-Wandlerschaltung mit einem Integrator bekannt, an den neben dem Messsignal abwechselnd unterschiedliche Pegel eines Referenzsignals angelegt werden.

Die US 4,031,532 offenbart eine A/D-Wandlerschaltung zur Wandlung einer Verstimmungsspannung einer Messbrücke. Die Schaltung weist einen Integrator auf, an den neben dem Verstimmungssignal ein von der Brückenspeisespannung abgeleitetes Referenzsignal angelegt wird, dessen Polarität zur Auf- und Abintegration umgeschaltet wird. Die Polarität der Speisespannung bleibt hingegen konstant.

Die DE 3710904 A1 offenbart eine Anordnung und ein Verfahren zur Digitalumsetzung analoger Meßgrößen in Brückenschaltungen mit schaltbaren Speisespannung- und Referenzspannungsquellen.

### Aufgabenstellung

Es ist die Aufgabe der vorliegenden Erfindung, Messverstärker-Vorrichtungen und -Verfahren derart weiterzubilden, dass eine gute Offset- und Driftreduktion von Vorverstärkern ohne Einbringung zusätzlicher, hochfrequenter aber auflösungsbegrenzter Elemente ermöglicht wird.

### Darstellung der Erfindung

Diese Aufgabe wird mit den Merkmalen des von Anspruch 1 sowie den Merkmalen von Anspruch 8 gelöst.

Erfindungsgemäß vorgeschlagen wird ein Messverstärkungsvorrichtung zur Erfassung einer Verstimmung einer mit einer bipolaren, rechteckförmigen Speisespannung gespeisten Messbrücke, mit einem integrierenden A/D-Wandler, der einen digitalen, für die Brückenverstimmung repräsentativen Ausgangswert auf Basis eines analogen, bipolaren Verstimmungssignals der Messbrücke erzeugt,
wobei der A/D-Wandler aufweist:
- einen Integrator, der das Verstimmungssignal oder ein von diesem abgeleitetes, bipolares Signal als bei Betrieb dauerhaft an ihn angelegtes Messsignal und einen zeitweise an ihn angelegten Arbeitspegel eines Referenzsignals integriert,
- einen dem Integrator nachgeschalteten Komparator, der ein Integrator-Ausgangssignal mit einem Schwellenwert vergleicht,
- Zeitmessmittel, die die Dauer jedes Messintervalls, während dessen der Arbeitspegel des Referenzsignals an den Integrator angelegt ist, als Basis eines Maßes für die Brückenverstimmung bestimmen,
wobei der Komparator jeden Zeitpunkt, zu dem das Integrator-Ausgangssignal den Schwellenwert quert, ermittelt und Steuermittel in Abhängigkeit von den ermittelten Querungszeitpunkten
- eine schaltbare Speisespannungsquelle zu einem Polaritätswechsel der Speisespannung und
- eine schaltbare Referenzspannungsquelle zum Trennen des Arbeitspegels des Referenzsignals von dem Integrator
ansteuern, sodass das Referenzsignal und die Speisespannung zueinander synchronisiert bipolar sind.

Weiter erfindungsgemäß vorgeschlagen wird ein Messverstärkungsverfahren zur Erfassung einer Verstimmung einer mit einer bipolaren, rechteckförmigen Speisespannung gespeisten Messbrücke, bei dem mittels eines integrierenden A/D-Wandlers ein digitaler, für die Brückenverstimmung repräsentativer Ausgangswert auf Basis eines analogen, bipolaren Verstimmungssignals der Messbrücke erzeugt wird, wobei
- von einem Integrator des A/D-Wandlers das an ihn dauerhaft als Messsignal angelegte Verstimmungssignal oder ein von diesem abgeleitetes, bipolares Signal und ein zeitweise an ihn angelegter Arbeitspegel eines Referenzsignals integriert werden,
- ein Integrator-Ausgangssignal mit einem Schwellenwert vergleichen wird und
- die Dauer jedes Messintervalls, während dessen der Arbeitspegel des Referenzsignal an den Integrator angelegt ist, erfasst und als Basis für die Ermittlung eines Maßes für die Brückenverstimmung verwendet wird
wobei jeder Zeitpunkt, zu dem das Integrator-Ausgangssignal den Schwellenwert quert, ermittelt wird und in Abhängigkeit von den ermittelten Querungszeitpunkten
- eine schaltbare Speisespannungsquelle zu einem Polaritätswechsel der Speisespannung und
- eine schaltbare Referenzspannungsquelle zum Trennen des Arbeitspegels des Referenzsignals von dem Integrator
angesteuert werden, sodass sich eine Synchronisierung der Polaritäten der Speisespannung und des Referenzsignals ergibt.

Zunächst ist erfindungsgemäß vorgesehen, dass die Speisespannungsquelle nicht als grundlegender Taktgeber fungiert, sondern von dem Komparator-Ausgangssignal abhängig ist. D.h., die jeweilige Umpolung des Speisespannungs-Rechtecks erfolgt in Abhängigkeit vom Schwellenwert-Durchgang des Integrator-Ausgangssignals, insbesondere von dessen Null-Durchgang. Weiter ist erfindungsgemäß vorgesehen, dass als Messsignal für den A/D-Wandler kein gleichgerichtetes Signal sondern das bipolare Verstimmungssignal selbst oder ein, insbesondere durch Wechselspannungs-Vorverstärkung, abgeleitetes, bipolares Signal verwendet wird. Schließlich ist erfindungsgemäß vorgesehen, dass auch als Referenzsignal ein bipolares Signal verwendet wird, welches bezüglich seiner Polarität mit der Speisespannung synchronisiert ist. Dies bedeutet mit anderen Worten, dass die Polaritätswechsel von Speisespannung und Referenzsignal wohldefiniert zueinander erfolgen.

Grundidee der vorliegenden Erfindung ist eine direkte Digitalisierung des gegebenenfalls vorverstärkten Verstimmungssignals durch jeweilige Anpassung des Referenzsignals an die Polarität des Messsignals, welche durch die Polarität der Speisespannung bestimmt wird. Während zweier aufeinander folgender Integrationsphasen wird der Kondensator des Integrators in umgekehrter Richtung geladen und nachfolgend wieder entladen. Wie aus dem Stand der Technik bekannt, wird dabei als Messintervall die Entladezeit, d.h. diejenige Zeit, während derer der Arbeitspegel des Referenzsignals anliegt, als Maß für den Pegel des Messsignals und somit für die Brückenverstimmung gemessen.

Ein wesentlicher Vorteil der vorliegenden Erfindung ist der resultierende Verzicht auf die im Stand der Technik erforderliche Gleichrichtung und Tiefpassfilterung des analogen Messsignals. Hierdurch werden Bauteile und mit diesen verbundene Fehlerquellen eingespart. Andererseits erübrigt sich auch eine "Gleichrichtung" im digitalen Bereich, d.h. Mittelwert- und Differenzbildung im überabgetasteten, bipolar digitalisierten Messsignal, die zu den oben bereits erläuterten Nachteilen führt. Vielmehr fällt die Gleichrichtung als "natürliches" Ergebnis der Digitalisierung mit bipolarem Referenzsignal ab.

Besonders bevorzugte Ausführungsformen der vorliegenden Erfindung sind in den abhängigen Ansprüchen definiert.

So ist es vorteilhaft, wenn die schaltbare Speisespannungsquelle zusammen mit einem zusätzlichen Referenzsignalschalter als schaltbare Referenzspannungsquelle dient. Dies vermeidet die Notwendigkeit zweier Spannungsquellen, die mit zusätzlichen Synchronisierungsmitteln aufeinander abgestimmt werden müssen. Vielmehr kann die schaltbare Speisespannungsquelle eine bipolare Quelle sein, deren positiver und negativer Anschluss abwechselnd mittels eines in Abhängigkeit von dem Komparator-Ausgangssignal gesteuerten Schalters mit der Messbrücke verbunden werden kann. Das resultierende, bipolare Rechtecksignal kann über einen ebenfalls in Abhängigkeit von dem Komparator-Ausgangssignal gesteuerten Schalter dem Integrator als Referenzsignal zugeführt werden.

Günstigerweise ist die Abhängigkeit der Speisespannung und des Referenzsignals von dem Komparator-Ausgangssignal so konkretisiert, dass der Komparator zur Ermittlung jedes Zeitpunktes einer Querung des Schwellenwertes durch das Integrator-Ausgangssignal, insbesondere des Null-Durchganges, eingerichtet ist und zur Rückkopplung des Komparator-Ausgangssignals Steuermittel vorgesehen sind, die in Abhängigkeit von dem ermittelten Querungszeitpunkt die schaltbare Speisespannungsquelle zu einem Polaritätswechsel der Speisespannung und die schaltbare Referenzspannungsquelle zum Trennen des Arbeitspegels des Referenzsignals von dem Integrator ansteuern. Mit anderen Worten ist vorzugsweise vorgesehen, dass beim Vergleichen des Integrator-Ausgangssignals mit einem Schwellenwert, insbesondere dem Null-Wert, der Zeitpunkt von dessen Querung durch das Integrator-Ausgangssignal erfasst wird und der Polaritätswechsel der Speisespannung sowie das Trennen des Arbeitspegels des Referenzsignals vom Integrator in Abhängigkeit von dem erfassten Zeitpunkt erfolgt. Typischweise ist die Steuerung so eingerichtet, dass Schwellwert-Querung bzw. Null-Durchgang des Integrator-Ausgangssignals, Polaritätswechsel der Speisespannung und Trennen des Arbeitspegels des Referenzsignals vom Integrator-Eingang im Wesentlichen gleichzeitig bzw. taktsynchron mit dem Takt eines zur Zeitmessung verwendeten, getakteten Zählers erfolgen. Es können jedoch gezielte Abweichungen von der taktsynchronen Gleichzeitigkeit eingestellt werden. Vergleichbare Abweichungen zur Verbesserung des Konvergenzverhaltens einer Messverstärkervorrichtung sind aus der bereits zitierten DE 100 40 373 A1 bekannt. Die dort offenbarten Prinzipien lassen sich auf einfache Weise auch auf die vorliegende Erfindung anwenden.

Bei einer besonders vorteilhaften Weiterbildung dieser Ausführungsform der Erfindung ist vorgesehen, dass die Steuermittel weiter eingerichtet sind, die schaltbare Referenzspannungsquelle jeweils nach einem vorbestimmten Zeitintervall nach dem Trennen des Arbeitspegels des Referenzsignals von dem Integrator zum erneuten Anlegen des Arbeitspegels des Referenzsignals an den Integrator anzusteuern. Bezogen auf das erfindungsgemäße Verfahren bedeutet dies, dass der Arbeitspegel des Referenzsignals jeweils nach einem vorbestimmten Zeitintervall nach dem Trennen des Arbeitspegels des Referenzsignals von dem Integrator erneut an den Integrator angelegt wird. Mit anderen Worten heißt das, dass die Zeitdauer, in der das Referenzsignal nicht bzw. der Ruhepegel des Referenzsignals am Integrator anliegt, somit die Zeitdauer, während derer der Kondensator des Integrators aufgeladen wird, im Wesentlichen fest eingestellt ist. Dem Integrator wird also eine vordefinierte Aufladezeit gewährt. Variabel und von der Menge der aufintegrierten Ladung abhängig ist hingegen die Entladezeit des Kondensators, d.h. die Zeit, während derer der Arbeitspegel des Referenzsignals anliegt. Diese Phase, das Messintervall, wird durch das Komparator-Ausgangssignal beendet und ihre Dauer wird als Maß für den Messsignalpegel bestimmt. Man beachte, dass bei dieser Ausführungsform der Erfindung zur Bestimmung des Messintervalls in der Praxis auch die Dauer des gesamten Messtaktes, d.h. der Dauer einer Auf- und einer Abintegrationsphase, was bei einer bevorzugten Ausführungsform der Erfindung gleich der Dauer zwischen zwei Polaritätswechseln der Speisespannung ist, als Maß für die Brückenverstimmung benutzt werden kann, da zu dem variablen Taktteil, d.h. dem Messintervall oder der Entladephase des Kondensators nur eine konstante Zeitdauer, nämlich die Dauer der Aufladephase des Kondensators hinzuaddiert wird.

Alternativ zu der zuvor geschilderten Variante mit variablem Messtakt kann bei einer anderen, ebenfalls günstigen Ausführungsform der Erfindung der Messtakt konstant gehalten werden. Hierzu ist vorgesehen, dass die Steuermittel weiter eingerichtet sind, die schaltbare Referenzspannungsquelle jeweils nach einem festen Zeitintervall nach einem vorangegangenen Anlegen des Arbeitspegels des Referenzsignals an den Integrator zum erneuten Anlegen des Arbeitspegels des Referenzsignals an den Integrator anzusteuern. Im Hinblick auf das erfindungsgemäße Verfahren bedeutet dies, dass der Arbeitspegel des Referenzsignals jeweils nach einem festen zeitintervall nach einem vorangegangenen Anlegen des Referenzsignals an den Integrator erneut an den Integrator angelegt wird. Mit anderen Worten bleibt die Zeitspanne zwischen zwei aufeinander folgenden Schaltvorgängen zum Anlegen des Arbeitspegels des Referenzsignals an den Integrator konstant. Variabel ist dagegen die Zeitspanne während derer der Arbeitspegel des Referenzsignals an den Integrator angelegt bleibt bzw. die Zeit, in der das Referenzsignal nicht bzw. der Ruhepegel des Referenzsignals an den Integrator angelegt ist. Variabel sind somit die Proportionen der Auflade- und Entladephase innerhalb eines festen Messtaktes. Man beachte, dass aufgrund der einfachen Abhängigkeit der Dauern von Entladephase und Aufladephase voneinander in der Praxis jede dieser Phasen zur Bestimmung des Messintervalls gemessen werden und als Basis für ein Maß für die Brückenverstimmung dienen kann.

Wie bereits erwähnt, stellen Offset und Drift eines gegebenenfalls eingesetzten Wechselspannungs-Vorverstärkers ein ernsthaftes Problem für die Genauigkeit der Messung der Brückenverstimmung dar. Ein Offset führt dazu, dass während zweier aufeinander folgender Messtakte mit verschiedener Polarität der Speisespannung unterschiedliche Messsignalpegel am Integrator anliegen. Die Drift führt hingegen dazu, dass sich ein solcher Offset nicht durch eine einmalige Einstellung eliminieren lässt, weil er sich mit der Zeit verändert, z.B. aufgrund von Temperatur oder Feuchte. Diese Veränderung erfolgt jedoch in der Regel sehr langsam im Vergleich zu der Dauer der Messtakte. Zur Eliminierung des zeitveränderlichen Offsets sind daher bei einer bevorzugten Weiterbildung der Erfindung Additionsmittel zur Aufsummierung einer geraden Anzahl von Messintervalldauern und Ausgabemittel zur Ausgabe eines Ausgabewertes auf Basis des aufsummierten Wertes als Maß für die Brückenverstimmung vorgesehen. Im Hinblick auf das erfindungsgemäße Verfahren bedeutet dies, dass eine gerade Anzahl aufeinander folgender Messintervalldauern aufsummiert werden und auf Basis des aufsummierten Wertes ein Maß für die Brückenverstimmung ausgegeben wird. Hierdurch wird der jeweils aktuelle Offset vollständig eliminiert.

Gleichzeitig wird durch die Aufsummierung der Messintervalldauern die Auflösung der Gesamtmessung verbessert. Eine unabhängige Messung einer Intervalldauer mittels eines getakteten Zählers ist mit einem Fehler von einem Zählertakt belegt. Es ist daher unmittelbar einleuchtend, dass eine kontinuierliche Messung, die eine (geradzahlige) Anzahl von Intervalldauern umfasst und ebenfalls nur mit einem Fehler von einem Zählertakt belegt ist, einen geringeren Relativfehler, d.h. eine bessere Auflösung aufweist. Die Auflösungsverbesserung kommt im vorliegenden Fall jedoch auch zustande, wenn eine (geradzahlige) Anzahl aufeinander folgender, separat gemessener Messintervalldauern aufaddiert werden. Dies liegt daran, dass aufgrund der taktsynchronen Steuerung des Referenzsignals die Dauern der Kondensator-Aufladeintervalle nicht unabhängig sind von den Dauern der Messintervalle, zwischen denen sie eingebettet sind, d.h. die Regeln der sog. Gauß' schen Fehlerfortpflanzung nicht anwendbar sind. Der auflösungsverbessernde Effekt der Aufsummierung einer geradzahligen Anzahl von Messintervalldauern ergibt sich daher bei jeder der oben beschriebenen Varianten.

Vorzugsweise ist vorgesehen, dass die Additionsmittel eingerichtet sind, einer aktuellen Bestimmung des aufsummierten Wertes die einer vorangegangenen Bestimmung zugrunde liegende Folge von Messintervalldauern ohne eine vorgegebene Anzahl von Dauern ältester Messintervalle und mit zusätzlich derselben Anzahl von Dauern jüngster, bei der vorangegangenen Bestimmung nicht berücksichtigter Messintervalle zugrunde zu legen. Bezogen auf das erfindungsgemäße Verfahren bedeutet dies, dass einer aktuellen Bestimmung des aufsummierten Wertes die einer vorangegangenen Bestimmung zugrunde liegende Folge von Messintervalldauern ohne eine vorgegebene Anzahl von Dauern ältester Messintervalle und mit zusätzlich derselben Anzahl Dauern jüngster, bei der vorangegangenen Bestimmung nicht berücksichtigter Messintervalle zugrunde gelegt werden. Mit anderen Worten wird die Folge von Messintervallen, deren Dauern jeweils für die Ermittlung eines offsetfreien Maßes für die Verstimmungsspannung aufsummiert werden, nach Art eines "gleitenden Fensters" bestimmt. Werden beispielsweise die zu den Zeiten t1, t2, t3 und t4 (mit t1 < t2 < t3 < t4) gemessenen Messintervalldauern zur Bestimmung des aufsummierten Wertes addiert, können bei einer nachfolgenden Bestimmung die zu den Zeiten t2, t3, t4 und t5 (mit t2 < t3 < t4 < t5) gemessenen Intervalldauern addiert werden. Auf diese Weise lässt sich nach jeder Bestimmung einer Messintervalldauer ein aktualisiertes Maß für die Verstimmung der Messbrücke ausgeben, wobei jeder aktuelle Ausgabewert von der aus der Aufsummierung resultierenden Offsetfreiheit und Auflösungshöhe profitiert. In diesem Beispiel wird das "gleitende Fenster" jeweils um ein Messintervall verschoben.

Selbstverständlich sind jedoch auch andere Schrittgröße der Verschiebung möglich.

Schließlich sei noch auf die Gefahr hingewiesen, dass durch die erfindungsgemäße Umpolung von Speise- und Referenzspannung eine zusätzliche Fehlerquelle erzeugt werden kann. Der hierdurch eingeführte Fehler wächst dabei mit der Häufigkeit der Umpolung. Bei einer Abwandlung der Erfindung kann daher vorgesehen sein, dass der Polaritätswechsel der Speisespannung und somit auch Referenzspannung nicht in jedem Messtakt, sondern nach nur in jedem n-ten Messtakt, d.h. nach jedem n-ten Messintervall angesteuert wird, wobei n vorzugsweise zwischen 2 und 100, insbesondere zwischen 2 und 10 liegt. Die konkrete Wahl von n ist in Abwägung des durch die Umschaltungshäufigkeit eingeführten Fehlers gegen die gesteigerte Reaktionsträgheit bei Wahl großer n zu treffen. Für die Eliminierung des Offsets durch Aufsummierung ist nämlich bei dieser Ausführungsform die Aufsummierung eines geradzahligen Vielfachen von n Messintervalldauern erforderlich. Die Wahl der Schrittgröße im Fall der Anwendung eines gleitenden Fensters ist bei dieser Variante hingegen nicht beschränkt.

### Kurzbeschreibung der Zeichnungen

Weitere Merkmale und Vorteile ergeben sich aus der nachfolgenden speziellen Beschreibung und den Zeichnungen. Es zeigen:
- Figur 1:: ein schematisches Ersatzschaltbild einer Ausführungsform der vorliegenden Erfindung,
- Figur 2:: ein schematisches Timing-Diagramm einer ersten Ausführungsform der vorliegenden Erfindung,
- Figur 3:: eine schematisches Timing-Diagramm einer zweiten Ausführungsform der vorliegenden Erfindung.

### Beschreibung bevorzugter Ausführungsformen

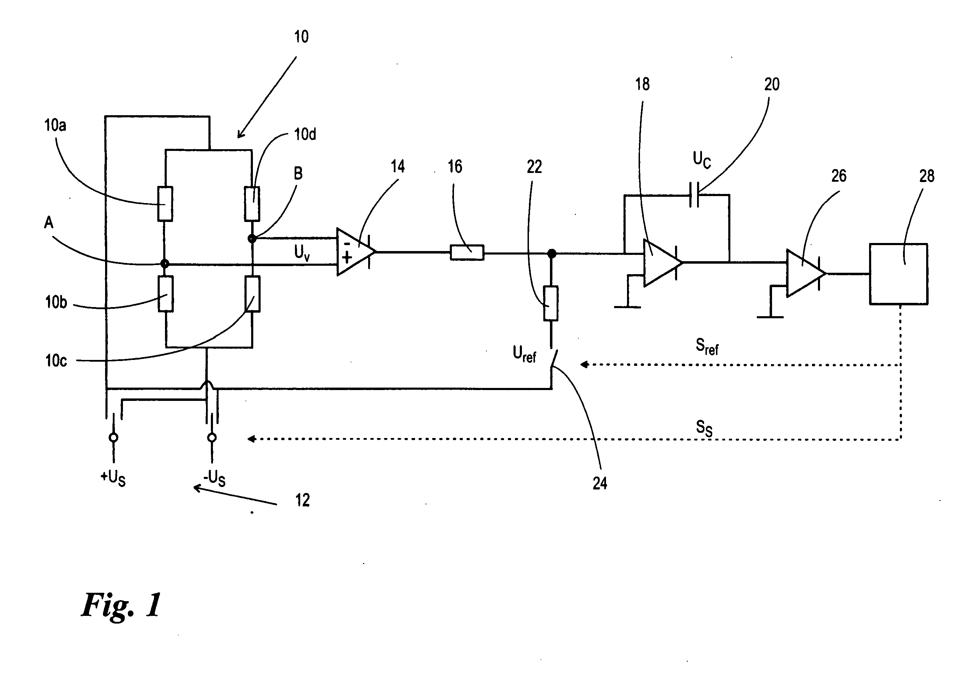

Figur 1 zeigt schematisch ein Ersatzschaltbild einer Vorrichtung gemäß der vorliegenden Erfindung. Im linken Bereich von Figur 1 ist eine aus vier Widerständen 10a, 10b, 10c und 10d aufgebaute Messbrücke 10 dargestellt. Derartige Messbrücken, bei denen wenigstens einer der Widerstände 10a-d veränderlich ist, werden in der Messtechnik vielfach verwendet. Insbesondere können ein oder mehrere der Widerstände 10a-d beispielsweise als Dehnmessstreifen ausgebildet sein, wie dies beispielsweise bei Präzisions-Kraftaufnehmern häufig der Fall ist. Die Messbrücke 10 wird von einer Speisespannungsquelle 12 mit einer Speisespannung U_{S} versorgt. Im Fall einer vollständig abgeglichenen Messbrücke 10 ist die Verstimmungsspannung U_{V}, die zwischen den Punkten A und B abgegriffen werden kann, gleich null. Eine Änderung des Widerstandswertes wenigstens eines der Widerstände 10a-d führt zu einer von Null verschiedenen Verstimmungsspannung U_{V}, die ein Maß für die zu messende Größe, z.B. die Verbiegung eines Kraftaufnehmerelementes, ist. Die Speisespannungsquelle 12 ist als schaltbare Speisespannungsquelle ausgebildet, die eine bipolare Speisespannung liefern kann. Bei der in Figur 1 dargestellten Ausführungsform wird dies durch synchrone Beschaltung der Ausgänge mit betragsgleichen Spannungen umgekehrter Polarität erreicht. Man beachte, dass die Darstellung von Figur 1 rein schematisch ist und lediglich die Funktionalität einer bipolaren, schaltbaren Speisespannungsquelle repräsentieren soll. Die Umschaltung der Polarität erfolgt jeweils in Abhängigkeit von einem an einem Steuereingang der Speisespannungsquelle 12 anliegenden Steuersignal S_{S}.

Entsprechend der bipolaren Speisung der Messbrücke 10 ergibt sich eine entsprechend bipolare Verstimmungsspannung U_{V}. Diese wird bei der Ausführungsform gemäß Figur 1 von einem Wechselspannungs-Vorverstärker 14 geeignet vorverstärkt. Der Vorverstärker 14 ist typischerweise Offset- und Driftbehaftet, so dass an dieser Stelle typischerweise zu eliminierende Fehler in die Messung einfließen.

Die Ausgangsspannung des Vorverstärkers 14 wird über einen Widerstand 16 in einen entsprechenden Strom umgewandelt, der an einen ersten Eingang eines als Integrator beschalteten Operationsverstärkers 18 angelegt wird. Der zweite Eingang des Operationsverstärkers 18 ist im vorliegenden Fall gegen Masse geschaltet, wobei jedoch auch jedes andere Konstantpotential grundsätzlich angelegt werden könnte. Die Beschaltung des Operationsverstärkers 18 als Integrator ist realisiert durch die Rückkopplung seines Ausgangssignals zu seinem ersten Eingang über den Integrationskondensator 20, über dem die Kondensator-Spannung U_{C} anliegt.

Ebenfalls an den ersten Eingang des Operationsverstärkers 18 angelegt ist eine über den Widerstand 22 in einem Strom umgewandelte Referenzspannung U_{ref}. Die Referenzspannung U_{ref} entspringt einer schaltbaren Referenzspannungsquelle, die in geeigneter Weise mit der Speisespannungsquelle 12 synchronisiert ist. Bei der in Figur 1 dargestellten Ausführungsform ist dies besonders vorteilhaft dadurch realisiert, dass als Referenzspannungsquelle die Speisespannungsquelle 12 zusammen mit einem zusätzlichen Schalter 24 Verwendung findet. Auf diese Weise ist sichergestellt, dass die Referenzspannung U_{ref} stets gleichzeitig mit der Speisespannung U_{S} einen Polaritätswechsel durchläuft, wobei jedoch durch den zusätzlichen Schalter 24 eine zusätzliche Taktung aufgeprägt werden kann. Der Schalter 24 wird über ein eigenes Steuersignal S_{ref} gesteuert. Man beachte, dass bei der gezeigten Ausführungsform die Referenzspannung U_{ref} entweder an den Eingang des Operationsverstärkers angelegt ist oder von diesem getrennt ist. Bei anderen denkbaren Ausführungsformen kann anstelle der Trennung ein Anlegen eines betragsmäßig niedrigeren Ruhepegels vorgesehen sein.

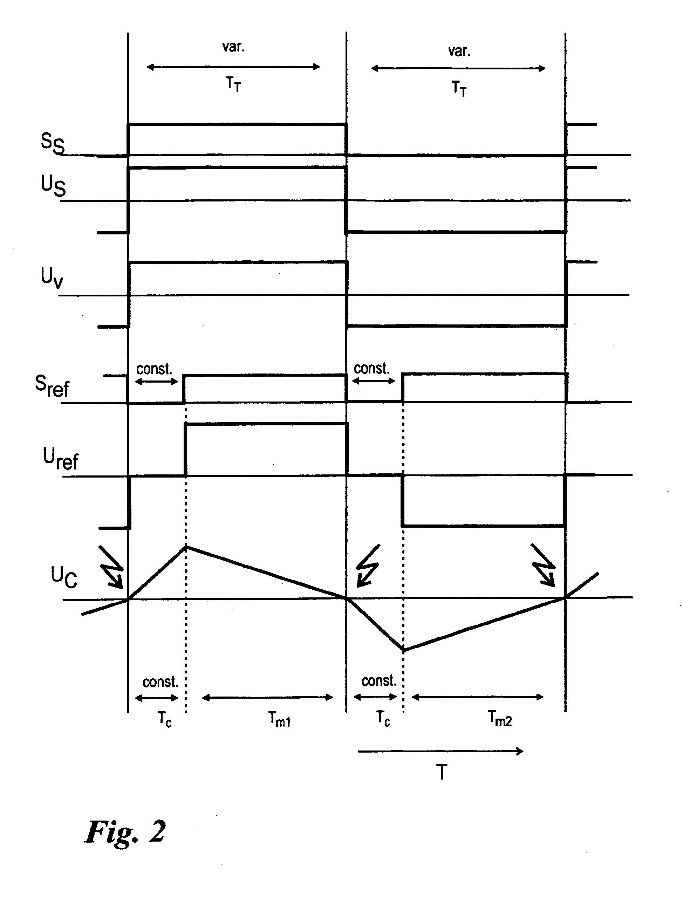

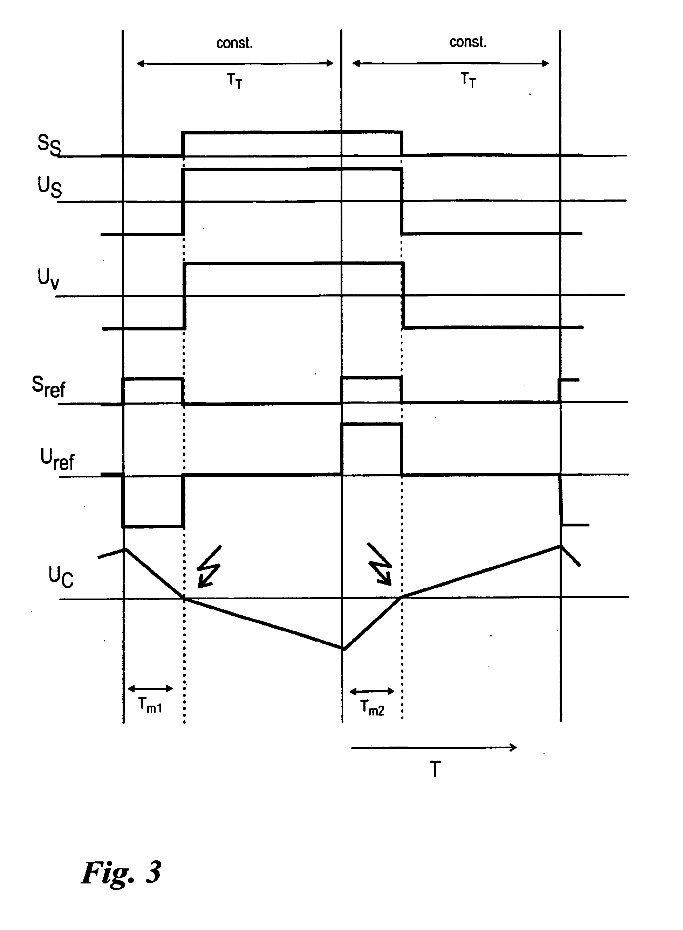

Dem Integrator aus Operationsverstärker 18 und Kondensator 20 nachgeschaltet ist ein Komparator 26, der in der gezeigten Ausführungsform als gegen Masse geschalteter Differenzverstärker ausgebildet ist. Bei anderen Ausführungsformen kann der Komparator auch gegen ein von Masse verschiedenes Potential geschaltet sein. Mit dem Komparator lassen sich die Zeitpunkte des Null-Durchgangs der Integrator-Ausgangsspannung erfassen. Dem Komparator 26 nachgeschaltete Steuermittel 28 verarbeiten das Komparator-Ausgangssignal zur Erzeugung der Steuersignale S_{S} und S_{ref} zur Ansteuerung der Speisespannungsquelle 12 bzw. der Referenzspannungsquelle, d.h. im Wesentlichen des Schalters 24 bei der Ausführungsform von Figur 1. Die Steuermittel 28 sind in Figur 1 als reiner Funktionsblock dargestellt und können auf unterschiedliche Weisen in reiner Hardware oder als eine Kombination aus Hardware und Software realisiert sein. Ihre Funktionsweise wird nachfolgend für zwei besonders bevorzugte Ausführungsformen der Erfindung anhand der Timing-Diagramme der Figuren 2 und 3 erläutert.

Figur 2 zeigt ein Timing-Diagramm gemäß einer ersten Ausführungsform der vorliegenden Erfindung. Die Darstellung ist lediglich zur Veranschaulichung der relativen, zeitlichen Verhältnisse der einzelnen Signale zueinander gedacht, wobei die Darstellung in willkürlichen Einheiten erfolgt. Wie bereits erläutert, folgt die bipolare Speisespannung U_{S} dem Steuersignal S_{S}, welches bei der dargestellten Ausführungsform ein monopolares Signal ist, aber selbstverständlich auch beispielsweise bipolar und/oder als Pulssignal ausgeführt sein könnte. Wesentlich ist, dass die Polaritätswechsel der Speisespannung U_{S} in Abhängigkeit von dem Steuersignal S_{S} erfolgen. Bei verstimmter Messbrücke 10 ergibt sich hieraus eine Verstimmungsspannung U_{V} am Ausgang der Messbrücke 10, die bezüglich ihrer Polaritätswechsel mit der Speisespannung synchron ist. Zur Vereinfachung der Darstellung ist das Ausgangssignal des invertierenden Vorverstärkers 14, welches gegenüber der Verstimmungsspannung U_{V} einen eventuell zeitlich veränderlichen Offset aufweisen kann, in Figur 2 nicht gezeigt. Man beachte, dass die invertierende Natur des Vorverstärkers 14 nicht erfindungsrelevant, sondern von der Richtung der zu erwartenden Verstimmung abhängig ist. Es kommt lediglich darauf an, dass das vorverstärkte Verstimmungssignal eine andere Polarität als das Referenzsignal aufweist.

Wie erläutert, zeigt die Referenzspannung U_{ref} im Wesentlichen dieselben Polaritätswechsel wie die Speisespannung U_{S}. Hinzu kommt die Taktung durch das Steuersignal S_{ref}. Bei der Ausführungsform gemäß Figur 2 wird die Referenzspannung U_{ref} zu Beginn jedes Messtaktes vom Eingang des Integrators 18, 20 getrennt. Während dieser Zeit liegt am Eingang des Operationsverstärkers 18 nur das Messsignal, d.h. die invertierend vorverstärkte Verstimmungsspannung U_{V} an. Während dieses ersten Taktanteils T_{C} des Messtaktes T_{T} lädt sich der Kondensator auf, was zu einem (betragsmäßigen) Anstieg der Kondensatorspannung U_{C} führt. Nach der vorbestimmten Zeit T_{C}, die bei der Ausführungsform von Figur 2 konstant ist, wird durch Umlegen des Schalters 24 in Abhängigkeit von dem Steuersignal S_{ref} zusätzlich die Referenzspannung U_{ref} an den Eingang des Integrators 18, 20 angelegt. Aufgrund ihrer zum Messsignal umgekehrten Polarität entlädt sich während des nun folgenden Taktanteils Tₘ der Kondensator 20 und zwar solange, bis die Kondensatorspannung U_{C} einen Null-Durchgang erfährt, der vom Komparator 26 registriert wird. Diese Zeitpunkte sind in Figur 2 durch Blitzpfeile gekennzeichnet. Der Zeitpunkt des Null-Durchgangs wird von den Steuermitteln 28 in eine taktsynchrone Änderung der Steuersignale S_{S} und S_{ref} übersetzt, so dass sich zum einen die Polarität der Speisespannung U_{S} und der Referenzspannung U_{ref} ändert und zusätzlich die Referenzspannung U_{ref} vom Eingang des Integrators 18, 20 getrennt wird. Der nachfolgende Messtakt läuft in derselben Weise wie oben beschrieben, jedoch bei umgekehrten Polaritäten ab.

Der Pegel der Verstimmungsspannung U_{V} wird durch diejenige zeitdauer repräsentiert, die erforderlich ist, um den Kondensator 20 nach einer konstanten Aufladezeit T_{c} wieder zu entladen, d.h. bis zum Null-Durchgang von U_{C}. Diese Zeitdauer ist das Messintervall Tₘ. Da die Aufladezeit T_{c}, wie erwähnt, konstant ist, kann sowohl die Dauer des Messintervalls Tₘ als auch die Dauer des gesamten Messtaktes T_{T} = T_{c} + Tₘ als Maß für den Pegel der Verstimmungsspannung U_{V} bestimmt werden. Die Erfassung der Dauer von Tₘ bzw. T_{T} = T_{c} + Tₘ erfolgt vorzugsweise über einen hochfrequenten Zähler, der mit Beginn von T_{c} oder Tₘ, vorzugsweise in Abhängigkeit von S_{ref} und/oder S_{S}, angestoßen wird. Die Erfassung der verschiedenen Intervalldauern kann mit einem einzigen Zähler erfolgen.

Wie erwähnt, kann es sein, dass durch den Vorverstärker 14 ein Offset in das Messsignal eingebracht wird. Dies würde bedeuten, dass die Intervalle unterschiedlicher Polarität unterschiedliche Pegel der Verstimmungsspannung U_{V} liefern würden. Dies wiederum hätte zur Folge, dass zwei aufeinander folgende Messtakte unterschiedlicher Polarität unterschiedliche Dauern hätten, wobei die Dauer eines Messtaktes um denselben Betrag zu lang wäre, wie die Dauer des anderen Messtaktes zu kurz wäre. Durch Addition zweier oder allgemeiner einer geradzahligen Mehrzahl von Messintervall- oder Messtaktdauern kann dieser Fehler daher korrigiert werden. Man beachte, dass diese Korrektur unabhängig von einer zeitlichen Drift des Offsets ist, sofern die Drift langsam im Vergleich zu der aufaddierten Gesamtdauer ist. Aufgrund der Konstanz der Aufladeperiode T_{c} können sowohl aufeinander folgende Messintervalle Tₘ₁ und Tₘ₂ auch die Dauern zweier aufeinander folgender vollständiger Messtakte (T_{c} + Tₘ₁) + (T_{c} + Tₘ₂) dienen. Hierdurch kann, wie weiter oben bereits erläutert, die Auflösung der Digitalisierung verbessert werden. Eine rasche Aktualisierung des ausgegebenen Maßes für die Verstimmung der Messbrücke kann durch Auswahl der aufzusummierenden Messintervalldauern nach der weiter oben erläuterten Methode des "gleitenden Fensters" erreicht werden.

Figur 3 zeigt ein schematisches Timing-Diagramm einer zweiten Ausführungsform der vorliegenden Erfindung, für dessen Darstellung ebenfalls das oben zur Darstellung von Figur 2 gesagte gilt. Im Unterschied zu der Ausführungsform gemäß Figur 2 ist in Figur 3 die Gesamtdauer jedes Messtaktes T_{T} konstant. Variabel sind lediglich die relativen Anteile der Aufladungsphase und des eigentlichen Messintervalls Tₘ, d.h. auch hier derjenigen zeit, die benötigt wird, um den aufgeladenen Kondensator durch zusätzliches Anlegen der Referenzspannung U_{ref} zu entladen.

Im Übrigen lässt sich das Timing-Diagramm der Figur 3 analog zu den Erläuterungen zu Figur 2 interpretieren. Man beachte, dass die unterschiedlichen Steigungen der einzelnen Abschnitte von U_{C} durch die relativen Pegel der (gegebenenfalls vorverstärkten) Verstimmungsspannung U_{V} und der Referenzspannung U_{ref} bedingt sind.

Natürlich kann von der strengen Synchronisierung der einzelnen, schaltbaren Signale geringfügig abgewichen werden, beispielsweise um bei starken Pegeländerungen der Verstimmungsspannung U_{V} eine rasche Konvergenz des digitalisierten Signals zu erreichen.

## Patentansprüche

1. Messverstärkungsvorrichtung zur Erfassung einer Verstimmung einer mit einer bipolaren, rechteckförmigen Speisespannung (U_{S}) gespeisten Messbrücke (10), mit einem integrierenden A/D-Wandler, der einen digitalen, für die Brückenverstimmung repräsentativen Ausgahgswert auf Basis eines analogen, bipolaren Verstimmungssignals (U_{V}) der Messbrücke (10) erzeugt,
wobei der A/D-Wandler aufweist:
- einen Integrator (18, 20), der das Verstimmungssignal (U_{V}) oder ein von diesem abgeleitetes, bipolares Signal als bei Betrieb dauerhaft an ihn angelegtes Messsignal und einen zeitweise an ihn angelegten Arbeitspegel eines Referenzsignals (U_{ref}) integriert,
- einen dem Integrator (18, 20) nachgeschalteten Komparator (26), der ein Integrator-Ausgangssignal mit einem Schwellenwert vergleicht,
- Zeitmessmittel, die die Dauer jedes Messintervalls (Tₘ), während dessen der.Arbeitspegel des Referenzsignals (U_{ref}) zusätzlich zu dem Messingnal an den Integrator (18, 20) angelegt ist, als Basis eines Maßes für die Brückenverstimmung bestimmen,
wobei der Komparator (26) jeden Zeitpunkt, zu dem das Integrator-Ausgangssignal den Schwellenwert quert, ermittelt und Steuermittel (28)
- eine schaltbare Speisespannungsquelle (12) zu einem Polaritätswechsel der Speisespannung (U_{S}) und
- eine schaltbare Referenzspannungsquelle (12, 24) zum Trennen des Arbeitspegels des Referenzsignals (U_{ref}) von dem Integrator (18, 20)
ansteuern, sodass das Referenzsignal und die Speisespannung zueinander synchronisiert bipolar sind;
**dadurch gekennzeichnet, dass** die schaltbare Speisespannungsquelle (12) und die schaltbare Referenzspannungsquelle (12, 24) von den Steuermittel (28) in Abhängigkeit von den ermittelten Querungszeitpunkten angesteuert werden.

2. Vorrichtung nach Anspruch 1
**dadurch gekennzeichnet,**
**dass** die schaltbare Speisespannungsquelle (12) zusammen mit einem zusätzlichen Referenzsignalschalter als schaltbare Referenzspannungsquelle (24) dient.

3. Vorrichtung nach einem der vorangehenden Ansprüche,
**dadurch gekennzeichnet,**
**dass** die Steuermittel (28) weiter eingerichtet sind, die schaltbare Referenzspannungsquelle (12, 24) jeweils nach einem vorbestimmten Zeitintervall (T_{c}) nach dem Trennen des Arbeitspegels des Referenzsignals (U_{ref}) von dem Integrator (18, 20) zum erneuten Anlegen des Arbeitspegels des Referenzsignals (U_{ref}) an den Integrator (18, 20) anzusteuern.

4. Vorrichtung nach Anspruch 3,
**dadurch gekennzeichnet,**
**dass** die Gesamtdauer zwischen zwei aufeinander folgenden Polaritätswechseln der Speisespannung (U_{S}) als Basis für das Maß für die Brückenverstimmung dienst.

5. Vorrichtung nach einem der Ansprüche 1 bis 2,
**dadurch gekennzeichnet,**
**dass** die Steuermittel weiter eingerichtet sind, die schaltbare Referenzspannungsquelle (12, 24) jeweils nach einem festen Zeitintervall (T_{T}) nach einem vorangegangenen Anlegen des Arbeitspegels des Referenzsignals (U_{ref}) an den Integrator (18, 20) zum erneuten Anlegen des Arbeitspegels des Referenzsignals (U_{ref}) an den Integrator (18, 20) anzusteuern.

6. Vorrichtung nach einem der vorangehenden Ansprüche
**dadurch gekennzeichnet,**
**dass** Additionsmittel zur Aufsummierung einer geraden Anzahl von Messintervalldauern und Ausgabemittel zur Ausgabe eines Ausgabewertes auf Basis des aufsummierten Wertes als Maß für die Brückenverstimmung vorgesehen sind.

7. Vorrichtung nach Anspruch 6,
**dadurch gekennzeichnet,**
**dass** die Additionsmittel eingerichtet sind, einer aktuellen Bestimmung des aufsummierten Wertes die einer vorangegangenen Bestimmung zugrunde liegende Folge von Messintervalldauern ohne eine vorgegebene Anzahl von Dauern ältester Messintervalle und mit zusätzlich derselben Anzahl Dauern jüngster, bei der vorangegangenen Bestimmung nicht berücksichtigter Messintervalle zugrunde zu legen.

8. Messverstärkungsverfahren zur Erfassung einer Verstimmung einer mit einer bipolaren, rechteckförmigen Speisespannung (U_{S}) gespeisten Messbrücke (10), bei dem mittels eines integrierenden A/D-Wandlers ein digitaler, für die Brückenverstimmung repräsentativer Ausgangswert auf Basis eines analogen, bipolaren Verstimmungssignals (U_{V}) der Messbrücke (10) erzeugt wird, wobei
- von einem Integrator (18, 20) des A/D-Wandlers das an ihn dauerhaft als Messsignal angelegte Verstimmungssignal (U_{V}) oder ein von diesem abgeleitetes, bipolares Signal und ein zeitweise an ihn angelegter Arbeitspegel eines Referenzsignals (U_{ref}) integriert werden,
- ein Integrator-Ausgangssignal mit einem Schwellenwert vergleichen wird und
- die Dauer jedes Messintervalls (Tₘ), während dessen der Arbeitspegel des Referenzsignal (U_{ref}) zusätzlich zu dem Messintervall an den Integrator (18, 20) angelegt ist, erfasst und als Basis für die Ermittlung eines Maßes für die Brückenverstimmung verwendet wird
wobei jeder Zeitpunkt, zu dem das Integrator-Ausgangssignal den Schwellenwert quert, ermittelt wird und
- eine schaltbare Speisespannungsquelle (12) zu einem Polaritätswechsel der Speisespannung (U_{S}) und
- eine schaltbare Referenzspannungsquelle (12, 14) zum Trennen des Arbeitspegels des Referenzsignals (U_{ref}) von dem Integrator
angesteuert werden, sodass sich eine Synchronisierung der Polaritäten der Speisespannung (U_{S}) und des Referenzsignals (U_{ref}) ergibt;
**dadurch gekennzeichnet, dass** die schaltbare Speisespannugsquelle (12) und die schaltbare Referenzspannungsquelle (12, 24) in Abhängigkeit von der ermittelten Querungszeitpunkten angesteuert werden.

9. Verfahren nach Anspruch 8,
**dadurch gekennzeichnet,**
**dass** der Arbeitspegel des Referenzsignals (U_{ref}) jeweils nach einem vorbestimmten Zeitintervall (T_{c}) nach dem Trennen des Arbeitspegels des Referenzsignals (U_{ref}) von dem Integrator (18, 20) erneut an den Integrator (18, 20) angelegt wird.

10. Verfahren nach Anspruch 9,
**dadurch gekennzeichnet,**
**dass** die Gesamtdauer (T_{T}) zwischen zwei aufeinander folgenden Polaritätswechseln der Speisespannung (U_{S}) als Basis für das Maß für die Brückenverstimmung verwendet wird.

11. Verfahren nach Anspruch 8,
**dadurch gekennzeichnet,**
**dass** der Arbeitspegel des Referenzsignals (U_{ref}) jeweils nach einem festen Zeitintervall (T_{T}) nach einem vorangehenden Anlegen des Arbeitspegels des Referenzsignals (U_{ref}) an den Integrator (18, 20) erneut an den Integrator (18, 20) angelegt wird.

12. Verfahren nach einem der Ansprüche 8 bis 11,
**dadurch gekennzeichnet,**
**dass** eine gerade Anzahl aufeinander folgender Messintervalldauern aufsummiert werden und auf Basis des aufsummierten Wertes ein Maß für die Brückenverstimmung ausgegeben wird.

13. Verfahren nach Anspruch 12,
**dadurch gekennzeichnet,**
**dass** einer aktuellen Bestimmung des aufsummierten Wertes die einer vorangegangenen Bestimmung zugrunde liegende Folge von Messintervalldauern ohne eine vorgegebene Anzahl von Dauern ältester Messintervalle und mit zusätzlich derselben Anzahl von Dauern jüngster, bei der vorangegangenen Bestimmung nicht berücksichtigter Messintervalle zugrunde gelegt wird.

## Claims

1. Measurement amplification device for detection of detuning of a measuring bridge (10) supplied by a bipolar square-wave supply voltage (U_{S}), with an integrating A/D converter which produces a digital output value, which is representative of the bridge detuning, on the basis of an analog bipolar detuning signal (U_{V}) of the measuring bridge (10), wherein the A/D converter comprises:
- an integrator (18, 20), which integrates the detuning signal (U_{V}) or a bipolar signal, which is derived therefrom, as a measuring signal permanently applied thereto during operation, and a working level, which is periodically applied thereto during operation, of a reference signal (U_{ref}),
- a comparator (26) which is connected downstream of the integrator (18, 20) and which compares an integrator output signal with a threshold value,
- time measuring means, which as a basis of a measure for the bridge detuning determine the duration of each measuring interval (Tₘ) during which the operating level of the reference signal (U_{ref}) is applied to the integrator (18, 20) additionally to the measuring signal,
wherein the comparator (26) ascertains every time instant at which the integrator output signal crosses the threshold value, and control means (28) control
- a switchable supply voltage source (12) for a polarity change of the supply voltage (U_{S}) and
- a switchable reference voltage source (12, 24) for separation of the operating level of the reference signal (U_{ref}) from the integrator (18, 20)
so that the reference signal and the supply voltage have bipolar synchronisation with one another;
**characterised in that** the switchable supply voltage source (12) and the switchable reference voltage source (12, 24) are controlled by the control means (28) in dependence on the ascertained crossing-time instants.

2. Device according to claim 1, **characterised in that** the switchable supply voltage source (12) serves together with an additional reference signal switch as the switchable reference voltage source (24).

3. Device according to one of the preceding claims, **characterised in that** the control means (28) are further arranged to control the switchable reference voltage source (12, 24) in each instance after a predetermined time interval (T_{c}) after separation of the operating voltage of the reference signal (U_{ref}) from the integrator (18, 20) for re-application of the operating level of the reference signal (U_{ref}) to the integrator (18, 20).

4. Device according to claim 3, **characterised in that** the total duration between two successive polarity changes of the supply voltage (U_{S}) serves as a basis for the measure for the bridge detuning.

5. Device according to one of claims 1 and 2, **characterised in that** the control means (28) is further arranged to control the switchable reference voltage source (12, 24) in each instance after a fixed time interval (T_{T}) after a preceding application of the operating level of the reference signal (U_{ref}) to the integrator (18, 20) for re-application of the operating level of the reference signal (U_{ref}) to the integrator (18, 20).

6. Device according to any one of the preceding claims, **characterised in that** addition means for summation of an even number of measuring interval durations and output means for output of an output value on the basis of the summated value as a measure for the bridge detuning are provided.

7. Device according to claim 6, **characterised in that** the addition means are arranged to base a current determination of the summated value on the succession, on which a preceding determination was based, of measuring interval durations without a preset number of durations of oldest measuring intervals and with in addition the same number of durations of the youngest measuring intervals not taken into consideration in the preceding determination.

8. Measurement amplification method for detection of detuning of a measuring bridge (10) supplied with a bipolar square-wave supply voltage (U_{S}), in which a digital output value, which is representative of the bridge detuning, is generated by means an integrating A/D converter on the basis of an analog bipolar detuning signal (U_{V}) of the measuring bridge (10), wherein
- integration is carried out by an integrator (18, 20) of the A/D converter of the detuning signal (U_{V}), which is constantly applied thereto as a measurement signal, or a bipolar signal derived therefrom and of an operating level, which is periodically applied thereto, of a reference signal (U_{ref}),
- an integrator output signal is compared with a threshold value and
- the duration of each measuring interval (Tₘ) during which the operating level of the reference signal (U_{ref}) is applied to the integrator (18, 20) additionally to the measuring interval is detected and used as a basis for ascertaining a measure for the bridge detuning,
wherein each time instant at which the integrator output signal crosses the threshold value is determined, and
- a switchable supply voltage source (12) is controlled for a polarity change of the supply voltage (U_{S}) and
- a switchable reference voltage source (12, 14) is controlled for separation of the operating level of the reference signal (U_{ref}) from the integrator,
so that a synchronisation of the polarities of the supply voltage (U_{S}) and the reference signal (U_{ref}) results;
**characterised in that** the switchable supply voltage source (12) and the switchable reference voltage source (12, 24) are controlled in dependence on the ascertained crossing-time instants.

9. Method according to claim 8, **characterised in that** the operating level of the reference signal (U_{ref}) is re-applied to the integrator (18, 20) in each instance after a predetermined time interval (T_{c}) after the separation of the operating level of the reference signal (U_{ref}) from the integrator (18, 20).

10. Method according to claim 9, **characterised in that** the total duration (T_{T}) between two successive polarity changes of the supply voltage (U_{S}) is used as a basis for the measure for the bridge detuning.

11. Method according to claim 8, **characterised in that** the operating level of the reference signal (U_{ref}) is re-applied to the integrator (18, 20) in each instance after a fixed time interval (T_{T}) after a preceding application of the operating level of the reference signal (U_{ref}) to the integrator (18, 20).

12. Method according to any one of claims 8 to 11, **characterised in that** an even number of successive measuring interval durations is summated and a measure for the bridge detuning is output on the basis of the summated value.

13. Method according to claim 12, **characterised in that** a current determination of the summated value is based on the succession, on which a preceding determination was based, of measuring interval durations without a preceding number of durations of oldest measuring intervals and with in addition the same number of durations of the youngest measuring intervals not taken into consideration in the preceding determination.

## Revendications

1. Dispositif d'amplification de mesure pour la saisie d'un désaccord d'un pont de mesure (10) alimenté par une tension d'alimentation bipolaire rectangulaire (U_{S}) avec un encodeur analogique/numérique à intégration qui génère une valeur de sortie numérique représentative pour le désaccord du pont sur la base d'un signal de désaccord analogique bipolaire (Uv) du pont de mesure (10),
où l'encodeur analogique/numérique comporte :
- un intégrateur (18, 20) qui intègre le signal de désaccord (U_{V}) ou un signal bipolaire dérivé de celui-ci en tant que signal de mesure qui lui est durablement appliqué en service, ainsi qu'un niveau opérationnel d'un signal de référence (U_{ref}) qui lui est temporairement appliqué,
- un comparateur (26) disposé en aval de l'intégrateur (18, 20), lequel compare un signal de sortie de l'intégrateur à une valeur seuil,
- des moyens de mesure temporelle qui déterminent la durée de chaque intervalle de mesure (Tₘ), pendant laquelle le niveau opérationnel du signal de référence (U_{ref}) est appliqué à l'intégrateur (18, 20) en plus du signal de mesure, en tant que base d'une mesure pour le désaccord du pont,
où le comparateur (26) détermine chaque moment auquel le signal de sortie de l'intégrateur croise la valeur seuil et où des moyens de commande (28) commandent
- une source de tension d'alimentation commutable (12) pour un changement de polarité de la tension d'alimentation (U_{S}) et
- une source de tension de référence commutable (12, 24) pour la déconnexion du niveau opérationnel du signal de référence (U_{ref}) de l'intégrateur (18, 20),
de manière que le signal de référence et la tension d'alimentation soient en synchronisation bipolaire entre eux ;
**caractérisé**
**en ce que** la source de tension d'alimentation commutable (12) et la source de tension de référence commutable (12, 24) sont commandées par les moyens de commande (28) en fonction des moments d'intersection déterminés.

2. Dispositif selon la revendication 1,
**caractérisé**
**en ce que** la source de tension d'alimentation commutable (12) sert de source de tension de référence commutable (24) avec un commutateur de signal de référence supplémentaire.

3. Dispositif selon l'une des revendications précédentes,
**caractérisé**
**en ce que** les moyens de commande (28) sont en outre réalisés pour commander la source de tension de référence commutable (12, 24) à réappliquer le niveau opérationnel du signal de référence (U_{ref}) à l'intégrateur (18, 20), après un intervalle temporel défini (T_{C}) suivant la déconnexion du niveau opérationnel du signal de référence (U_{ref}) de l'intégrateur (18, 20).

4. Dispositif selon la revendication 3,
**caractérisé**
**en ce que** la durée totale entre deux changements de polarité successifs de la tension d'alimentation (U_{S}) sert de base pour la mesure de désaccord du pont.

5. Dispositif selon l'une des revendications 1 et 2,
**caractérisé**
**en ce que** les moyens de commande sont en outre réalisés pour commander la source de tension de référence commutable (12, 24) à réappliquer le niveau opérationnel du signal de référence (U_{ref}) à l'intégrateur (18, 20), après un intervalle temporel fixe (T_{T}) suivant une application précédente du niveau opérationnel du signal de référence (U_{ref}) à l'intégrateur (18, 20).

6. Dispositif selon l'une des revendications précédentes,
**caractérisé**
**en ce que** sont prévus des moyens d'addition pour la totalisation d'un nombre pair de durées d'intervalles de mesure, ainsi que des moyens de sortie pour l'émission d'une valeur de sortie sur la base de la valeur d'addition en tant que mesure pour le désaccord du pont.

7. Dispositif selon la revendication 6,
**caractérisé**
**en ce que** les moyens d'addition sont réalisés pour prendre pour base d'une détermination actuelle de la valeur d'addition la suite de durées d'intervalles de mesure prise pour base d'une détermination précédente, sans un nombre défini de durées d'intervalles de mesure les plus anciens et avec en plus un nombre égal de durées d'intervalles de mesure les plus récents qui n'ont pas été pris en compte lors de la détermination précédente.

8. Procédé d'amplification de mesure pour la saisie d'un désaccord d'un pont de mesure (10) alimenté par une tension d'alimentation bipolaire rectangulaire (U_{S}), où, au moyen d'un encodeur analogique/numérique à intégration, une valeur de sortie numérique représentative pour le désaccord du pont est générée sur la base d'un signal de désaccord analogique bipolaire (U_{V}) du pont de mesure (10), où
- le signal de désaccord (U_{V}) durablement appliqué en tant que signal de mesure à un intégrateur (18, 20) de l'encodeur analogique/numérique, ou un signal bipolaire dérivé de celui-ci, ainsi qu'un niveau opérationnel d'un signal de référence (U_{ref}) qui lui est temporairement appliqué sont intégrés par ledit intégrateur (18, 20),
- un signal de sortie de l'intégrateur est comparé à une valeur seuil, et
- la durée de chaque intervalle de mesure (Tₘ), pendant lequel le niveau opérationnel du signal de référence (U_{ref}) est appliqué à l'intégrateur (18, 20) en plus du signal de mesure, est saisie et exploitée en tant que base de détermination d'une mesure pour le désaccord du pont,
où chaque moment auquel le signal de sortie de l'intégrateur croise la valeur seuil est saisi, et où sont commandées
- une source de tension d'alimentation commutable (12) pour un changement de polarité de la tension d'alimentation (U_{S}) et
- une source de tension de référence commutable (12, 24) pour la déconnexion du niveau opérationnel du signal de référence (U_{ref}) de l'intégrateur, de manière à obtenir une synchronisation des polarités de la tension d'alimentation (U_{S}) et du signal de référence (U_{ref}) ;
**caractérisé**
**en ce que** la source de tension d'alimentation commutable (12) et la source de tension de référence commutable (12, 24) sont commandées en fonction des moments d'intersection déterminés.

9. Procédé selon la revendication 8,
**caractérisé**
**en ce que** le niveau opérationnel du signal de référence (U_{ref}) est réappliqué à l'intégrateur (18, 20), après un intervalle temporel défini (T_{C}) suivant la déconnexion du niveau opérationnel du signal de référence (U_{ref}) de l'intégrateur (18, 20).

10. Procédé selon la revendication 9,
**caractérisé**
**en ce que** la durée totale (T_{T}) entre deux changements de polarité successifs de la tension d'alimentation (U_{S}) sert de base pour la mesure de désaccord du pont.

11. Procédé selon la revendication 8,
**caractérisé**
**en ce que** le niveau opérationnel du signal de référence (U_{ref}) est réappliqué à l'intégrateur (18, 20), après un intervalle temporel fixe (T_{T}) suivant une application précédente du niveau opérationnel du signal de référence (U_{ref}) à l'intégrateur (18, 20).

12. Procédé selon l'une des revendications 8 à 11,
**caractérisé**
**en ce qu'**un nombre pair de durées d'intervalles de mesure successives est totalisé et en ce qu'une mesure pour le désaccord du pont est émise sur la base de la valeur d'addition.

13. Procédé selon la revendication 12,
**caractérisé**
**en ce qu'**est prise pour base d'une détermination actuelle de la valeur d'addition la suite de durées d'intervalles de mesure prise pour base d'une détermination précédente, sans un nombre défini de durées d'intervalles de mesure les plus anciens et avec en plus un nombre égal de durées d'intervalles de mesure les plus récents qui n'ont pas été pris en compte lors de la détermination précédente.
